# EUROPEAN PATENT APPLICATION

(11) **EP 4 152 096 A1**
(43) Date of publication of application: **22.03.2023**
(21) Application number: 21197008.2
(22) Date of filing: 15.09.2021
(51) Int. Cl.: G03F 7/20

(54) **SYSTEM AND METHOD FOR INSPECTION BY FAILURE MECHANISM CLASSIFICATION AND IDENTIFICATION IN A CHARGED PARTICLE SYSTEM**

(71) Applicant: ASML Netherlands B.V., 5500 AH Veldhoven (NL)
(72) Inventor: WOESSNER, Achim, Eindhoven (NL); SONG, Younghoon, Osan-si (KR); NIKOLSKI, Pioter, Veldhoven (NL); SUNG, Yun A, Hwa-Sung (KR); CORRADI, Antonio, Veldhoven (NL); DILLEN, Hermanus, Adrianus, Maarheeze (NL)
(74) Representative: ASML Netherlands B.V.

(57) **Abstract**

Apparatuses, systems, and methods for providing beams for classifying and identifying failure mechanisms associated with a sample of charged particle beam systems. In some embodiments, a method may include analyzing a first plurality of voltage contrast images of a sample to identify a plurality of defects; and analyzing a pattern of a subset of the plurality of defects to determine a failure mechanism for the subset of the plurality of defects.

## Description

### FIELD

The description herein relates to the field of charged particle beam systems, and more particularly to systems for using voltage contrast to classify and identify failure mechanisms associated with a sample of charged particle beam system inspection systems.

### BACKGROUND

In manufacturing processes of integrated circuits (ICs), unfinished or finished circuit components are inspected to ensure that they are manufactured according to design and are free of defects. An inspection system utilizing an optical microscope typically has resolution down to a few hundred nanometers; and the resolution is limited by the wavelength of light. As the physical sizes of IC components continue to reduce down to sub-100 or even sub-10 nanometers, inspection systems capable of higher resolution than those utilizing optical microscopes are needed.

A charged particle (e.g., electron) beam microscope, such as a scanning electron microscope (SEM) or a transmission electron microscope (TEM), capable of resolution down to less than a nanometer, serves as a practicable tool for inspecting IC components having a feature size that is sub-100 nanometers. With a SEM, electrons of a single primary electron beam, or electrons of a plurality of primary electron beams, can be focused at locations of interest of a wafer under inspection. The primary electrons interact with the wafer and may be backscattered or may cause the wafer to emit secondary electrons. The intensity of the electron beams comprising the backscattered electrons and the secondary electrons may vary based on the properties of the internal and external structures of the wafer, and thereby may indicate whether the wafer has defects.

### SUMMARY

Embodiments of the present disclosure provide apparatuses, systems, and methods for classifying and identifying failure mechanisms associated with a sample of charged particle beam systems. In some embodiments, a method may include analyzing a first plurality of voltage contrast images of a sample to identify a plurality of defects; and analyzing a pattern of a subset of the plurality of defects to determine a failure mechanism for the subset of the plurality of defects.

In some embodiments, a system for classifying and identifying failure mechanisms may include a controller including circuitry that may be configured to cause a system to perform analyzing a first plurality of voltage contrast images of a sample to identify a plurality of defects; and analyzing a pattern of a subset of the plurality of defects to determine a failure mechanism for the subset of the plurality of defects.

In some embodiments, a non-transitory computer readable medium may store a set of instructions that is executable by at least one processor of a computing device to cause the computing device to perform a method for classifying and identifying failure mechanisms. The method may include analyzing a first plurality of voltage contrast images of a sample to identify a plurality of defects; and analyzing a pattern of a subset of the plurality of defects to determine a failure mechanism for the subset of the plurality of defects.

In some embodiments, a system for classifying and identifying failure mechanisms may include a controller including circuitry that may be configured to cause a system to perform generating a first plurality of voltage contrast patterns based on a plurality of perturbation simulations; determining a relationship between the plurality of perturbation simulations and the first plurality of voltage contrast patterns; generating a second plurality of voltage contrast patterns; and identifying a failure mechanism based on the second plurality of voltage contrast patterns and the plurality of relationships.

In some embodiments, a method for classifying and identifying failure mechanisms may include generating a first plurality of voltage contrast patterns based on a plurality of perturbation simulations; determining a relationship between the plurality of perturbation simulations and the first plurality of voltage contrast patterns; generating a second plurality of voltage contrast patterns; and identifying a failure mechanism based on the second plurality of voltage contrast patterns and the plurality of relationships.

In some embodiments, a non-transitory computer readable medium may store a set of instructions that is executable by at least one processor of a computing device to cause the computing device to perform a method for classifying and identifying failure mechanisms. The method may include generating a first plurality of voltage contrast patterns based on a plurality of perturbation simulations; determining a relationship between the plurality of perturbation simulations and the first plurality of voltage contrast patterns; generating a second plurality of voltage contrast patterns; and identifying a failure mechanism based on the second plurality of voltage contrast patterns and the plurality of relationships.

In some embodiments, a system for classifying and identifying failure mechanisms may include a controller including circuitry that may be configured to cause a system to perform generating a first plurality of voltage contrast patterns based on a plurality of perturbation simulations; classifying a failure mechanism associated with the first plurality of voltage contrast based on a plurality of relationships between the plurality of perturbation simulations and the first plurality of voltage contrast patterns; generating a second plurality of voltage contrast patterns; and identifying, using the classified plurality of failure mechanisms, a failure mechanism associated with the second plurality of voltage contrast patterns

In some embodiments, a system for classifying and identifying failure mechanisms may include a controller including circuitry that may be configured to cause a system to perform generating a first plurality of voltage contrast images based on a plurality of perturbation simulations, wherein the first plurality of voltage contrast images comprise a first plurality of voltage contrast patterns; constructing a classifier by comparing the first plurality of voltage contrast images and determining a relationship between the plurality of perturbation simulations and the first plurality of voltage contrast patterns; generating a second plurality of voltage contrast images during inspection, wherein the second plurality of voltage contrast images comprise a second plurality of voltage contrast patterns; identifying, using the classifier, a failure mechanism based on the second plurality of voltage contrast patterns.

### BRIEF DESCRIPTION OF THE DRAWINGS

Fig. 1 is a schematic diagram illustrating an exemplary electron beam inspection (EBI) system, consistent with embodiments of the present disclosure.
Fig. 2 is a schematic diagram illustrating an exemplary multi-beam system that is part of the exemplary charged particle beam inspection system of Fig. 1, consistent with embodiments of the present disclosure.
Fig. 3 is an exemplary graph showing a yield rate of secondary electrons relative to landing energy of primary electron beamlets, consistent with embodiments of the present disclosure.
Fig. 4 is a schematic diagram illustrating an exemplary a voltage contrast response of a wafer, consistent with embodiments of the present disclosure.
Fig. 5A and Fig. 5B are schematic diagrams illustrating voltage contrast responses of samples, consistent with embodiments of the present disclosure.
Fig. 6 is a schematic diagram of a system for classifying and identifying failure mechanisms associated with a sample, consistent with embodiments of the present disclosure.
Fig. 7 is a schematic diagram illustrating an exemplary process of classifying and identifying failure mechanisms associated with a sample, consistent with embodiments of the present disclosure.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the disclosure. Instead, they are merely examples of apparatuses and methods consistent with aspects related to the subject matter recited in the appended claims. For example, although some embodiments are described in the context of utilizing electron beams, the disclosure is not so limited. Other types of charged particle beams may be similarly applied. Furthermore, other imaging systems may be used, such as optical imaging, photodetection, x-ray detection, extreme ultraviolet inspection, deep ultraviolet inspection, or the like.

Electronic devices are constructed of circuits formed on a piece of silicon called a substrate. Many circuits may be formed together on the same piece of silicon and are called integrated circuits or ICs. The size of these circuits has decreased dramatically so that many more of them can fit on the substrate. For example, an IC chip in a smart phone can be as small as a thumbnail and yet may include over 2 billion transistors, the size of each transistor being less than 1/1000th the size of a human hair.

Making these extremely small ICs is a complex, time-consuming, and expensive process, often involving hundreds of individual steps. Errors in even one step have the potential to result in defects in the finished IC rendering it useless. Thus, one goal of the manufacturing process is to avoid such defects to maximize the number of functional ICs made in the process, that is, to improve the overall yield of the process.

One component of improving yield is monitoring the chip making process to ensure that it is producing a sufficient number of functional integrated circuits. One way to monitor the process is to inspect the chip circuit structures at various stages of their formation. Inspection may be carried out using a scanning electron microscope (SEM). A SEM can be used to image these extremely small structures, in effect, taking a "picture" of the structures of the wafer. The image can be used to determine if the structure was formed properly and also if it was formed at the proper location. If the structure is defective, then the process can be adjusted so the defect is less likely to recur. Defects may be generated during various stages of semiconductor processing. For the reason stated above, it is important to find defects accurately and efficiently as early as possible.

The working principle of a SEM is similar to a camera. A camera takes a picture by receiving and recording brightness and colors of light reflected or emitted from people or objects. A SEM takes a "picture" by receiving and recording energies or quantities of electrons reflected or emitted from the structures. Before taking such a "picture," an electron beam may be provided onto the structures, and when the electrons are reflected or emitted ("exiting") from the structures, a detector of the SEM may receive and record the energies or quantities of those electrons to generate an image. To take such a "picture," some SEMs use a single electron beam (referred to as a "single-beam SEM"), while some SEMs use multiple electron beams (referred to as a "multi-beam SEM") to take multiple "pictures" of the wafer. By using multiple electron beams, the SEM may provide more electron beams onto the structures for obtaining these multiple "pictures," resulting in more electrons exiting from the structures. Accordingly, the detector may receive more exiting electrons simultaneously, and generate images of the structures of the wafer with a higher efficiency and a faster speed.

Voltage contrast metrology is used as an early proxy for electric yield associated with a sample (e.g., during inspection of dynamic random-access memories). SEM images including voltage contrast patterns typically show a random occurrence of failures associated with a sample and the voltage contrast patterns themselves typically have a random "pattern" (e.g., varying grey scale levels) of features.

However, defect detection analysis of typical voltage contrast defect patterns suffers from constraints during inspection of a sample because the analysis does not comprehend that there may be a relationship between an observed pattern of defects and a failure mechanism. In a representative inspection using voltage contrast metrology, only a defect and its position in a sample are recorded. The defect detection analysis of voltage contrast images generated during these inspections does not consider sample processing information (e.g., patterning steps, materials origin, etc. of a sample) that can be discerned by the sub-structure (e.g., patterns, layers within a sample, etc.) of defects. Moreover, defects in samples are typically difficult to classify.

Some of the disclosed embodiments provide systems and methods that address some or all of these disadvantages by classifying and identifying failure mechanisms associated with a sample. Some disclosed embodiments may determine relationships between perturbation simulations and voltage contrast patterns to construct a classifier, and use the classifier during inspection to classify failure mechanisms associated with a sample, thereby allowing automatic identification of the failure mechanisms associated with a sample during inspection. Other disclosed embodiments may determine relationships between observed patterns of defects in a voltage contrast image and failure mechanisms, thereby allowing automatic identification of the failure mechanisms associated with a sample during inspection. In a first example, features manufactured utilizing a self-aligned double patterning (SADP) process may have a defect that occurs in second rows of the features (e.g., every two rows of features), and the failure mechanism may be determined to be related to use of the SADP process based on this defect pattern. In a second example, features manufactured utilizing a self-aligned quadruple patterning (SAQP) process may have a defect that occurs in fourth rows of the features (e.g., every four rows of features), and the failure mechanism may be determined to be related to use of the SAQP process based on this defect pattern.

While a SADP process may be used to create a two feature pattern set, and a SAQP process may be used to create a 4 feature pattern set, there may be other features located between the SADP or SAQP created pattern sets. So while a defect may occur every two rows of features of a SADP pattern set or every four rows of features of a SAQP pattern set, since the sets of SADP/SAQP created features may not be adjacent to each other, the repeating patterns may not be continuous. In one example a SAQP process is used to create two pattern sets, and there are 10 features located between the pattern sets. The repeating pattern will include a first SAQP created feature of the first pattern set, and a corresponding first SAQP created feature of the second pattern set. However, since the 10 features located between the two SAQP pattern sets were not created with the SAQP process, they will not exhibit the defect associated with the SAQP process.

Relative dimensions of components in drawings may be exaggerated for clarity. Within the following description of drawings, the same or like reference numbers refer to the same or like components or entities, and only the differences with respect to the individual embodiments are described.

As used herein, unless specifically stated otherwise, the term "or" encompasses all possible combinations, except where infeasible. For example, if it is stated that a component may include A or B, then, unless specifically stated otherwise or infeasible, the component may include A, or B, or A and B. As a second example, if it is stated that a component may include A, B, or C, then, unless specifically stated otherwise or infeasible, the component may include A, or B, or C, or A and B, or A and C, or B and C, or A and B and C.

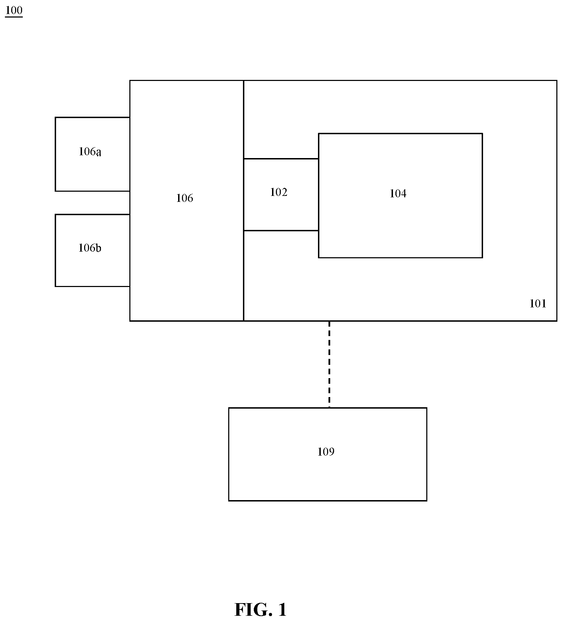

Fig. 1 illustrates an exemplary electron beam inspection (EBI) system 100 consistent with embodiments of the present disclosure. EBI system 100 may be used for imaging. As shown in Fig. 1, EBI system 100 includes a main chamber 101, a load/lock chamber 102, an electron beam tool 104, and an equipment front end module (EFEM) 106. Electron beam tool 104 is located within main chamber 101. EFEM 106 includes a first loading port 106a and a second loading port 106b. EFEM 106 may include additional loading port(s). First loading port 106a and second loading port 106b receive wafer front opening unified pods (FOUPs) that contain wafers (e.g., semiconductor wafers or wafers made of other material(s)) or samples to be inspected (wafers and samples may be used interchangeably). A "lot" is a plurality of wafers that may be loaded for processing as a batch.

One or more robotic arms (not shown) in EFEM 106 may transport the wafers to load/lock chamber 102. Load/lock chamber 102 is connected to a load/lock vacuum pump system (not shown) which removes gas molecules in load/lock chamber 102 to reach a first pressure below the atmospheric pressure. After reaching the first pressure, one or more robotic arms (not shown) may transport the wafer from load/lock chamber 102 to main chamber 101. Main chamber 101 is connected to a main chamber vacuum pump system (not shown) which removes gas molecules in main chamber 101 to reach a second pressure below the first pressure. After reaching the second pressure, the wafer is subject to inspection by electron beam tool 104. Electron beam tool 104 may be a single-beam system or a multi-beam system.

A controller 109 is electronically connected to electron beam tool 104. Controller 109 may be a computer configured to execute various controls of EBI system 100. While controller 109 is shown in Fig. 1 as being outside of the structure that includes main chamber 101, load/lock chamber 102, and EFEM 106, it is appreciated that controller 109 may be a part of the structure.

In some embodiments, controller 109 may include one or more processors (not shown). A processor may be a generic or specific electronic device capable of manipulating or processing information. For example, the processor may include any combination of any number of a central processing unit (or "CPU"), a graphics processing unit (or "GPU"), an optical processor, a programmable logic controllers, a microcontroller, a microprocessor, a digital signal processor, an intellectual property (IP) core, a Programmable Logic Array (PLA), a Programmable Array Logic (PAL), a Generic Array Logic (GAL), a Complex Programmable Logic Device (CPLD), a Field-Programmable Gate Array (FPGA), a System On Chip (SoC), an Application-Specific Integrated Circuit (ASIC), and any type circuit capable of data processing. The processor may also be a virtual processor that includes one or more processors distributed across multiple machines or devices coupled via a network.

In some embodiments, controller 109 may further include one or more memories (not shown). A memory may be a generic or specific electronic device capable of storing codes and data accessible by the processor (e.g., via a bus). For example, the memory may include any combination of any number of a random-access memory (RAM), a read-only memory (ROM), an optical disc, a magnetic disk, a hard drive, a solid-state drive, a flash drive, a security digital (SD) card, a memory stick, a compact flash (CF) card, or any type of storage device. The codes may include an operating system (OS) and one or more application programs (or "apps") for specific tasks. The memory may also be a virtual memory that includes one or more memories distributed across multiple machines or devices coupled via a network.

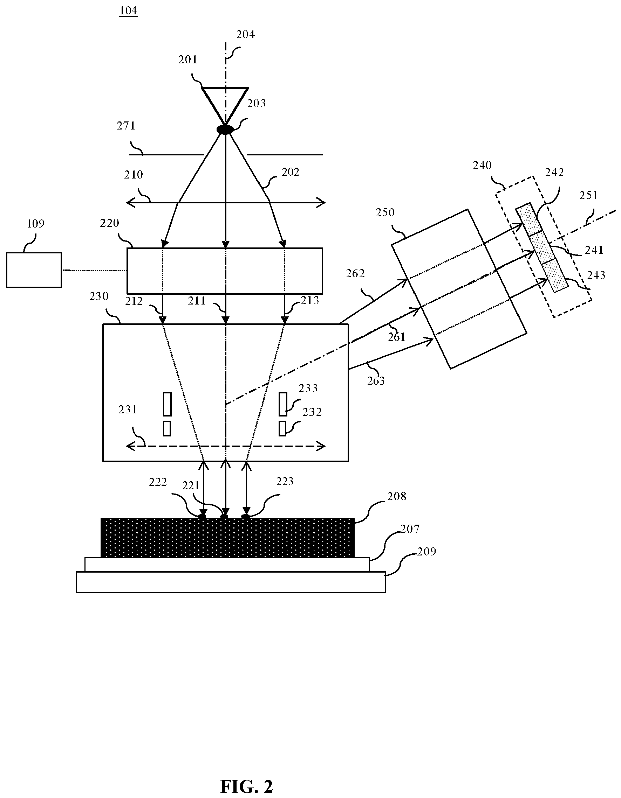

Reference is now made to Fig. 2, which is a schematic diagram illustrating an exemplary electron beam tool 104 including a multi-beam inspection tool that is part of the EBI system 100 of Fig. 1, consistent with embodiments of the present disclosure. In some embodiments, electron beam tool 104 may be operated as a single-beam inspection tool that is part of EBI system 100 of Fig. 1. Multi-beam electron beam tool 104 (also referred to herein as apparatus 104) comprises an electron source 201, a Coulomb aperture plate (or "gun aperture plate") 271, a condenser lens 210, a source conversion unit 220, a primary projection system 230, a motorized stage 209, and a sample holder 207 supported by motorized stage 209 to hold a sample 208 (e.g., a wafer or a photomask) to be inspected. Multi-beam electron beam tool 104 may further comprise a secondary projection system 250 and an electron detection device 240. Primary projection system 230 may comprise an objective lens 231. Electron detection device 240 may comprise a plurality of detection elements 241, 242, and 243. A beam separator 233 and a deflection scanning unit 232 may be positioned inside primary projection system 230.

Electron source 201, Coulomb aperture plate 271, condenser lens 210, source conversion unit 220, beam separator 233, deflection scanning unit 232, and primary projection system 230 may be aligned with a primary optical axis 204 of apparatus 104. Secondary projection system 250 and electron detection device 240 may be aligned with a secondary optical axis 251 of apparatus 104.

Electron source 201 may comprise a cathode (not shown) and an extractor or anode (not shown), in which, during operation, electron source 201 is configured to emit primary electrons from the cathode and the primary electrons are extracted or accelerated by the extractor and/or the anode to form a primary electron beam 202 that form a primary beam crossover (virtual or real) 203. Primary electron beam 202 may be visualized as being emitted from primary beam crossover 203.

Source conversion unit 220 may comprise an image-forming element array (not shown), an aberration compensator array (not shown), a beam-limit aperture array (not shown), and a pre-bending micro-deflector array (not shown). In some embodiments, the pre-bending micro-deflector array deflects a plurality of primary beamlets 211, 212, 213 of primary electron beam 202 to normally enter the beam-limit aperture array, the image-forming element array, and an aberration compensator array. In some embodiments, apparatus 104 may be operated as a single-beam system such that a single primary beamlet is generated. In some embodiments, condenser lens 210 is designed to focus primary electron beam 202 to become a parallel beam and be normally incident onto source conversion unit 220. The image-forming element array may comprise a plurality of micro-deflectors or micro-lenses to influence the plurality of primary beamlets 211, 212, 213 of primary electron beam 202 and to form a plurality of parallel images (virtual or real) of primary beam crossover 203, one for each of the primary beamlets 211, 212, and 213. In some embodiments, the aberration compensator array may comprise a field curvature compensator array (not shown) and an astigmatism compensator array (not shown). The field curvature compensator array may comprise a plurality of micro-lenses to compensate field curvature aberrations of the primary beamlets 211, 212, and 213. The astigmatism compensator array may comprise a plurality of micro-stigmators to compensate astigmatism aberrations of the primary beamlets 211, 212, and 213. The beam-limit aperture array may be configured to limit diameters of individual primary beamlets 211, 212, and 213. Fig. 2 shows three primary beamlets 211, 212, and 213 as an example, and it is appreciated that source conversion unit 220 may be configured to form any number of primary beamlets. Controller 109 may be connected to various parts of EBI system 100 of Fig. 1, such as source conversion unit 220, electron detection device 240, primary projection system 230, or motorized stage 209. In some embodiments, as explained in further details below, controller 109 may perform various image and signal processing functions. Controller 109 may also generate various control signals to govern operations of the charged particle beam inspection system.

Condenser lens 210 is configured to focus primary electron beam 202. Condenser lens 210 may further be configured to adjust electric currents of primary beamlets 211, 212, and 213 downstream of source conversion unit 220 by varying the focusing power of condenser lens 210. Alternatively, the electric currents may be changed by altering the radial sizes of beam-limit apertures within the beam-limit aperture array corresponding to the individual primary beamlets. The electric currents may be changed by both altering the radial sizes of beam-limit apertures and the focusing power of condenser lens 210. Condenser lens 210 may be an adjustable condenser lens that may be configured so that the position of its first principle plane is movable. The adjustable condenser lens may be configured to be magnetic, which may result in off-axis beamlets 212 and 213 illuminating source conversion unit 220 with rotation angles. The rotation angles change with the focusing power or the position of the first principal plane of the adjustable condenser lens. Condenser lens 210 may be an anti-rotation condenser lens that may be configured to keep the rotation angles unchanged while the focusing power of condenser lens 210 is changed. In some embodiments, condenser lens 210 may be an adjustable anti-rotation condenser lens, in which the rotation angles do not change when its focusing power and the position of its first principal plane are varied.

Objective lens 231 may be configured to focus beamlets 211, 212, and 213 onto a sample 208 for inspection and may form, in the current embodiments, three probe spots 221, 222, and 223 on the surface of sample 208. Coulomb aperture plate 271, in operation, is configured to block off peripheral electrons of primary electron beam 202 to reduce Coulomb effect. The Coulomb effect may enlarge the size of each of probe spots 221, 222, and 223 of primary beamlets 211, 212, 213, and therefore deteriorate inspection resolution.

Beam separator 233 may, for example, be a Wien filter comprising an electrostatic deflector generating an electrostatic dipole field and a magnetic dipole field (not shown in Fig. 2). In operation, beam separator 233 may be configured to exert an electrostatic force by electrostatic dipole field on individual electrons of primary beamlets 211, 212, and 213. The electrostatic force is equal in magnitude but opposite in direction to the magnetic force exerted by magnetic dipole field of beam separator 233 on the individual electrons. Primary beamlets 211, 212, and 213 may therefore pass at least substantially straight through beam separator 233 with at least substantially zero deflection angles.

Deflection scanning unit 232, in operation, is configured to deflect primary beamlets 211, 212, and 213 to scan probe spots 221, 222, and 223 across individual scanning areas in a section of the surface of sample 208. In response to incidence of primary beamlets 211, 212, and 213 or probe spots 221, 222, and 223 on sample 208, electrons emerge from sample 208 and generate three secondary electron beams 261, 262, and 263. Each of secondary electron beams 261, 262, and 263 typically comprise secondary electrons (having electron energy ≤ 50eV) and backscattered electrons (having electron energy between 50eV and the landing energy of primary beamlets 211, 212, and 213). Beam separator 233 is configured to deflect secondary electron beams 261, 262, and 263 towards secondary projection system 250. Secondary projection system 250 subsequently focuses secondary electron beams 261, 262, and 263 onto detection elements 241, 242, and 243 of electron detection device 240. Detection elements 241, 242, and 243 are arranged to detect corresponding secondary electron beams 261, 262, and 263 and generate corresponding signals which are sent to controller 109 or a signal processing system (not shown), e.g., to construct images of the corresponding scanned areas of sample 208.

In some embodiments, detection elements 241, 242, and 243 detect corresponding secondary electron beams 261, 262, and 263, respectively, and generate corresponding intensity signal outputs (not shown) to an image processing system (e.g., controller 109). In some embodiments, each detection element 241, 242, and 243 may comprise one or more pixels. The intensity signal output of a detection element may be a sum of signals generated by all the pixels within the detection element.

In some embodiments, controller 109 may comprise image processing system that includes an image acquirer (not shown), a storage (not shown). The image acquirer may comprise one or more processors. For example, the image acquirer may comprise a computer, server, mainframe host, terminals, personal computer, any kind of mobile computing devices, and the like, or a combination thereof. The image acquirer may be communicatively coupled to electron detection device 240 of apparatus 104 through a medium such as an electrical conductor, optical fiber cable, portable storage media, IR, Bluetooth, internet, wireless network, wireless radio, among others, or a combination thereof. In some embodiments, the image acquirer may receive a signal from electron detection device 240 and may construct an image. The image acquirer may thus acquire images of sample 208. The image acquirer may also perform various post-processing functions, such as generating contours, superimposing indicators on an acquired image, and the like. The image acquirer may be configured to perform adjustments of brightness and contrast, etc. of acquired images. In some embodiments, the storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

In some embodiments, the image acquirer may acquire one or more images of a sample based on an imaging signal received from electron detection device 240. An imaging signal may correspond to a scanning operation for conducting charged particle imaging. An acquired image may be a single image comprising a plurality of imaging areas. The single image may be stored in the storage. The single image may be an original image that may be divided into a plurality of regions. Each of the regions may comprise one imaging area containing a feature of sample 208. The acquired images may comprise multiple images of a single imaging area of sample 208 sampled multiple times over a time sequence. The multiple images may be stored in the storage. In some embodiments, controller 109 may be configured to perform image processing steps with the multiple images of the same location of sample 208.

In some embodiments, controller 109 may include measurement circuitries (e.g., analog-todigital converters) to obtain a distribution of the detected secondary electrons. The electron distribution data collected during a detection time window, in combination with corresponding scan path data of each of primary beamlets 211, 212, and 213 incident on the wafer surface, can be used to reconstruct images of the wafer structures under inspection. The reconstructed images can be used to reveal various features of the internal or external structures of sample 208, and thereby can be used to reveal any defects that may exist in the wafer.

In some embodiments, controller 109 may control motorized stage 209 to move sample 208 during inspection of sample 208. In some embodiments, controller 109 may enable motorized stage 209 to move sample 208 in a direction continuously at a constant speed. In other embodiments, controller 109 may enable motorized stage 209 to change the speed of the movement of sample 208 overtime depending on the steps of scanning process.

Although Fig. 2 shows that apparatus 104 uses three primary electron beams, it is appreciated that apparatus 104 may use two or more number of primary electron beams. The present disclosure does not limit the number of primary electron beams used in apparatus 104. In some embodiments, apparatus 104 may be a SEM used for lithography.

Compared with a single charged-particle beam imaging system ("single-beam system"), a multiple charged-particle beam imaging system ("multi-beam system") may be designed to optimize throughput for different scan modes. Embodiments of this disclosure provide a multi-beam system with the capability of optimizing throughput for different scan modes by using beam arrays with different geometries. adapting to different throughputs and resolution requirements.

A non-transitory computer readable medium may be provided that stores instructions for a processor (e.g., processor of controller 109 of Figs. 1-2) to carry out image processing, data processing, beamlet scanning, database management, graphical display, operations of a charged particle beam apparatus, or another imaging device, or the like. Common forms of non-transitory media include, for example, a floppy disk, a flexible disk, hard disk, solid state drive, magnetic tape, or any other magnetic data storage medium, a CD-ROM, any other optical data storage medium, any physical medium with patterns of holes, a RAM, a PROM, and EPROM, a FLASH-EPROM or any other flash memory, NVRAM, a cache, a register, any other memory chip or cartridge, and networked versions of the same.

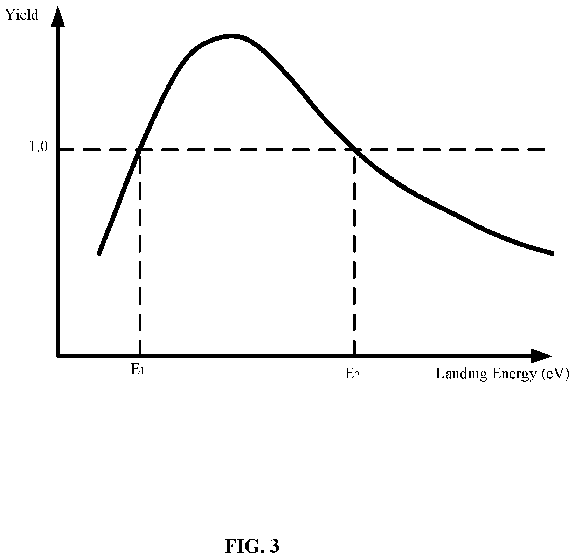

Fig. 3 illustrates an exemplary graph showing a yield rate of secondary electrons relative to landing energy of primary electron beamlets, consistent with embodiments of the present disclosure. The graph illustrates the relationship of the landing energy of a plurality of beamlets of a primary electron beam (e.g., plurality of beamlets 211, 212, or 213 of primary electron beam 202 of Fig. 2) and the yield rate of secondary electron beams (e.g., secondary electron beams 261, 262, or 263 of Fig. 2). The yield rate indicates the number of secondary electrons that are produced in response to the impact of the primary electrons. For example, a yield rate greater than 1.0 indicates that more secondary electrons may be produced than the number of primary electrons that have landed on the wafer. Similarly, a yield rate of less than 1.0 indicates that less secondary electrons may be produced in response to the impact of the primary electrons.

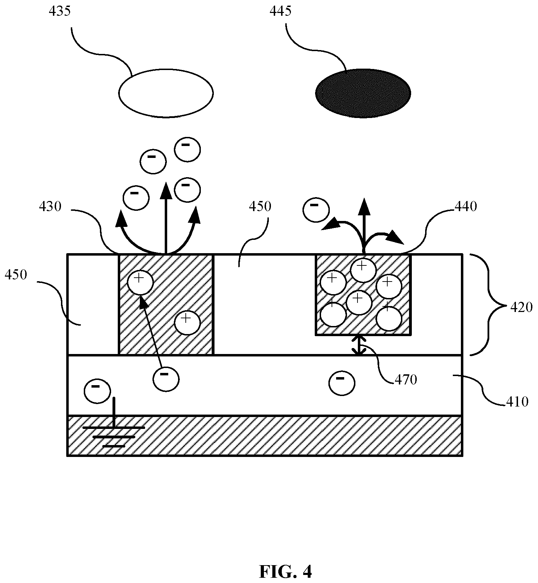

As shown in the graph of Fig. 3, when the landing energy of the primary electrons is within a range from E₁ to E₂, more electrons may leave the surface of the wafer than land onto the surface of the wafer, which may result in a positive electrical potential at the surface of the wafer. In some embodiments, defect inspection may be performed in the foregoing range of landing energies, which is called "positive mode." An electron beam tool (e.g., electron beam tool 104 of Fig. 2) may generate a darker voltage contrast image of a device structure with a more positive surface potential since a detection device (e.g., detection device 240 of Fig. 2) may receive less secondary electrons (see Fig. 4).

When the landing energy is lower than E₁ or higher than E₂, less electrons may leave the surface of the wafer, thereby resulting in a negative electrical potential at the surface of the wafer. In some embodiments, defect inspection may be performed in this range of the landing energies, which is called "negative mode." An electron beam tool (e.g., electron beam tool 104 of Fig. 2) may generate a brighter voltage contrast image of a device structure with a more negative surface potential a detection device (e.g., detection device 240 of Fig. 2) may receive more secondary electrons (see Fig. 4).

In some embodiments, the landing energy of the primary electron beams may be controlled by the total bias between the electron source and the wafer.

Fig. 4 illustrates a schematic diagram of a voltage contrast response of a wafer, consistent with embodiments of the present disclosure. In some embodiments, physical and electrical defects in a wafer (e.g., resistive shorts and opens, defects in deep trench capacitors, back end of line (BEOL) defects, etc.) can be detected using a voltage contrast method of a charged particle inspection system. Defect detection using voltage contrast images may use a pre-scanning process (i.e., a charging, flooding, neutralization, or prepping process), where charged particles are applied to an area of the wafer (e.g., sample 208 of Fig. 2) to be inspected before conducting the inspection.

In some embodiments, an electron beam tool (e.g., electron beam tool 104 of Fig. 2) may be used to detect defects in internal or external structures of a wafer by illuminating the wafer with a plurality of beamlets of a primary electron beam (e.g., plurality of beamlets 211, 212, or 213 of primary electron beam 202 of Fig. 2) and measuring a voltage contrast response of the wafer to the illumination. In some embodiments, the wafer may comprise a test device region 420 that is developed on a substrate 410. In some embodiments, test device region 420 may include multiple device structures 430 and 440 separated by insulating material 450. For example, device structure 430 is connected to substrate 410. In contrast, device structure 440 is separated from substrate 410 by insulating material 450 such that a thin insulator structure 470 (e.g., thin oxide) exists between device structure 440 and substrate 410.

The electron beam tool may generate secondary electrons (e.g., secondary electron beams 261, 262, or 263 of Fig. 2) from the surface of test device region 420 by scanning the surface of test device region 420 with a plurality of beamlets of a primary electron beam. As explained above, when the landing energy of the primary electrons is between E₁ and E₂ (i.e., the yield rate is greater than 1.0 in Fig. 3), more electrons may leave the surface of the wafer than land on the surface, thereby resulting in a positive electrical potential at the surface of the wafer.

As shown in Fig. 4, a positive electrical potential may build-up at the surface of a wafer. For example, after an electron beam tool scans test device region 420 (e.g., during a pre-scanning process), device structure 440 may retain more positive charges because device structure 440 is not connected to an electrical ground in substrate 410, thereby resulting in a positive electrical potential at the surface of device structure 440. In contrast, primary electrons with the same landing energy (i.e., the same yield rate) applied to device structure 430 may result in less positive charges retained in device structure 430 since positive charges may be neutralized by electrons supplied by the connection to substrate 410.

An image processing system (e.g., controller 109 of Fig. 2) of an electron beam tool may generate voltage contrast images 435 and 445 of corresponding device structures 430 and 440, respectively. For example, device structure 430 is shorted to the ground and may not retain built-up positive charges. Accordingly, when primary electron beamlets land on the surface of the wafer during inspection, device structure 430 may repel more secondary electrons thereby resulting in a brighter voltage contrast image. In contrast, because device structure 440 has no connection to substrate 410 or any other grounds, device structure 440 may retain a build-up of positive charges. This build-up of positive charges may cause device structure 440 to repel less secondary electrons during inspection, thereby resulting in a darker voltage contrast image.

An electron beam tool (e.g., multi-beam electron beam tool 104 of Fig. 2) may pre-scan the surface of a wafer by supplying electrons to build up the electrical potential on the surface of the wafer. After pre-scanning the wafer, the electron beam tool may obtain images of multiple dies within the wafer. Pre-scanning is applied to the wafer under the assumption that the electrical surface potential built-up on the surface of the wafer during pre-scanning will be retained during inspection and will remain above the detection threshold of the electron beam tool.

However, the built-up surface potential level may change during inspection due to the effects of electrical breakdown or tunneling, thereby resulting in failure to detect defects. For example, when a high voltage is applied to a high resistance thin device structure (e.g., thin oxide), such as an insulator structure 470, leakage current may flow through the high resistance structure, thereby preventing the structure from functioning as a perfect insulator. This may affect circuit functionality and result in a device defect. A similar effect of leakage current may also occur in a structure with improperly formed materials or a high resistance metal layer, for example a cobalt silicide (e.g., CoSi, CoSi₂, Co₂Si, Co₃Si, etc.) layer between a tungsten plug and a source or drain area of a field-effect transistor (FET).

A defective etching process may leave a thin oxide resulting in unwanted electrical blockage (e.g., open circuit) between two structures (e.g., device structure 440 and substrate 410) intended to be electrically connected. For example, device structures 430 and 440 may be designed to make contact with substrate 410 and function identically, but due to manufacturing errors, insulator structure 470 may exist in device structure 440. In this case, insulator structure 470 may represent a defect susceptible to a breakdown effect.

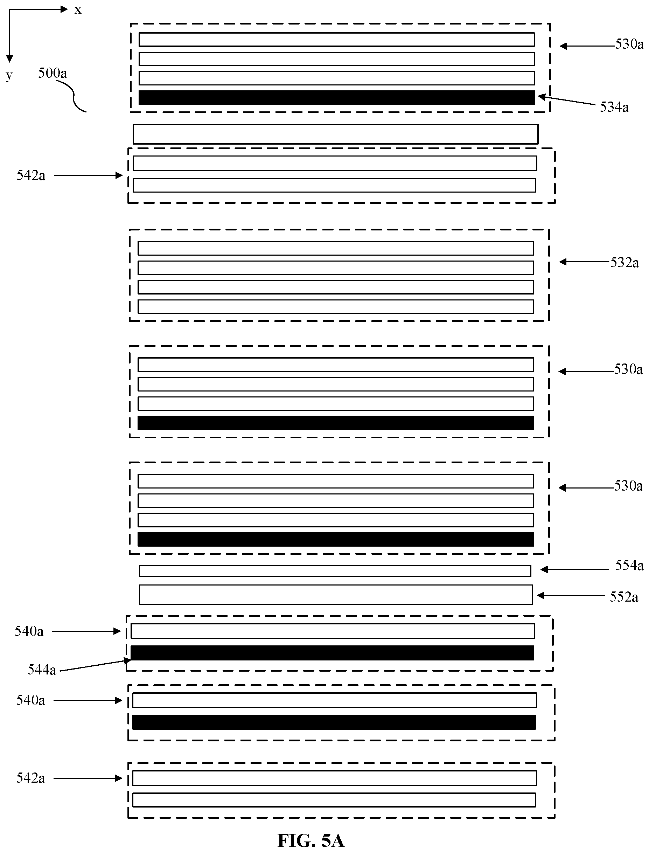

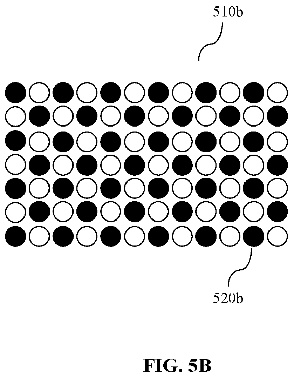

Fig. 5A and Fig. 5B illustrate schematic diagrams illustrating voltage contrast responses of samples, consistent with embodiments of the present disclosure.

In some embodiments, voltage contrast images of a sample (e.g., sample 208 of Fig. 2) may include patterns (e.g., defect patterns, repetitive patterns, etc.) that may indicate one or more underlying defects in the sample.

For example, samples may be processed by self-aligned double patterning (SADP) or self-aligned quadruple patterning (SAQP). In some embodiments, samples processed by SADP or SAQP may have a pitch walking defect. A pitch walking defect is a defect where the pitch between features alternates in a sample. Pitch walking defects may be caused by a misalignment of masks during sample processing or deviations in a pre-patterned feature critical dimension.

During inspection of a sample processed by SADP or SAQP, one or more voltage contrast images of the sample may be generated. In some embodiments, the voltage contrast images of a sample that is processed by SADP or SAQP or a combination of processes may include a voltage contrast image 500a. In some embodiments, voltage contrast image 500a may include pattern sets of features on a sample. In some embodiments, a sample may include a combination pattern sets, where each pattern set may be processed in a different, or the same, manner. For example, a first pattern set may be processed using a first type of mask (e.g., processed using SADP or SAQP) and a second pattern set may be processed using a second type of mask (e.g., processed using SAQP or SADP).

In some embodiments, some pattern sets may include defects while some pattern sets may not include defects. Pattern sets with defects may be adjacent to pattern sets with defects or adjacent to pattern sets without defects. In some embodiments, pattern sets may have different types of defects, which may be observed in voltage contrast image 500a. In some embodiments, more than one pattern set with the same type of defect (e.g., pitch walking defects from SADP or SAQP related processing) may be included on a sample (e.g., the defect type may repeat on the sample).

For example, voltage contrast image 500a may include pattern sets 530a with a defect in a feature 534a. The defect in feature 534a may occur in multiple pattern sets 530a of four features (e.g., the defect may repeat) on the sample, which may indicate a failure mechanism related to the use of an SAQP process used in pattern sets 530a. In some embodiments, a pattern set 530a may be adjacent to another pattern set 530a while in some embodiments a pattern set 530a may be adjacent to different types of features (e.g., a pattern set 530a may be adjacent to a pattern set 554a that is not processed by SAQP, a pattern set 530a may be adjacent to a pattern set 532a that is processed by SAQP without a defect, etc.).

In some embodiments, voltage contrast image 500a may include pattern sets 540a with a defect in a feature 544a. The defect in feature 544a may occur in multiple pattern sets 540a of two features (e.g., the defect may repeat) on the sample, which may indicate a failure mechanism related to the use of an SADP process used in pattern sets 540a. In some embodiments, a pattern set 540a may be adjacent to another pattern set 540a while in some embodiments a pattern set 540a may be adjacent to different types of features (e.g., a pattern set 540a may be adjacent to a pattern set 552a that is not processed by SADP, a pattern set 540a may be adjacent to a pattern set 542a that is processed by SADP without a defect, etc.).

It should be appreciated that defects in features in voltage contrast image 500a may be depicted in a different manner. For example, in some embodiments defects in a feature may be depicted by uneven lines (e.g., waves) on a feature.

While voltage contrast image 500a may depict features extending in the x direction, it should be appreciated that voltage contrast images may depict any combination of features extending in the y direction, features extending in the x and y directions, features extending in directions other than x or y, etc.

In some embodiments, voltage contrast images of a sample may include a voltage contrast pattern 510b with a checkerboard pattern of features 520b (e.g., features that alternate in grey scale levels) in the sample. Voltage contrast pattern 510b may indicate that the sample includes an overlay defect between layers of the sample.

It should be noted that voltage contrast patterns are not limited to the arrangement or grey scale levels of features depicted in voltage contrast image 500a or voltage contrast pattern 510b.

In conventional methods of inspection, pattern sets with defects in voltage contrast image 500a and voltage contrast pattern 510b may not be identifiable (e.g., failure mechanisms associated with voltage contrast image 500a or voltage contrast pattern 510b may be unknown) since conventional methods only analyze individual features in voltage contrast images without analyzing a voltage contrast pattern.

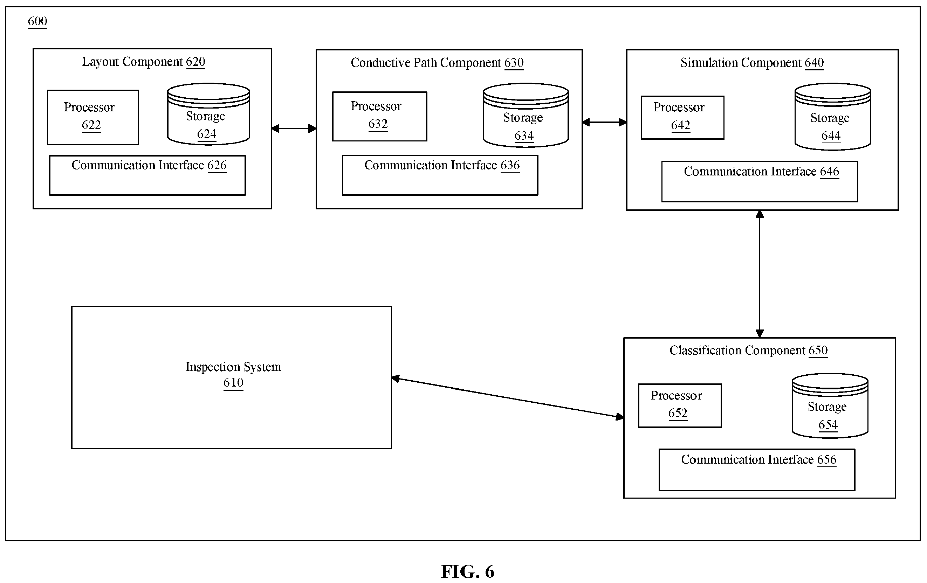

Fig. 6 illustrates a schematic diagram of a system 600 for classifying and identifying failure mechanisms associated with a sample (e.g., sample 208 of Fig. 2). System 600 may include an inspection system 610, a layout component 620, a conductive path component 630, a simulation component 640, and a classification component 650. Inspection system 610, layout component 620, conductive path component 630, simulation component 640, and classification component 650 may be electrically coupled (directly or indirectly) to each other, either physically (e.g., by a cable) or remotely. Inspection system 610 may be the system described with respect to Figs. 1 and 2, used to acquire images of a wafer (see, e.g., sample 208 of Fig. 2). In some embodiments, components of system 600 may be implemented as one or more servers (e.g., where each server includes its own processor). In some embodiments, components of system 600 may be implemented as software that may pull data from one or more databases of system 600. In some embodiments, system 600 may include one server or a plurality of servers. In some embodiments, system 600 may include one or more modules that are implemented by a controller (e.g., controller 109 of Fig. 1, controller 109 of Fig. 2).

Layout component 620 may include a processor 622 and a storage 624. Layout component 320 may also include a communication interface 626 to send data to conductive path component 630. Processor 622 may be configured to select one or more layout designs, such as resist layout designs to be used for development (e.g., lithography) of a sample or final layer layout designs. In some embodiments, layout designs may reflect an internal design of a sample. A layout design may include one or more layout structures (e.g., layout of features) that may be developed on the sample. In some embodiments, one or more layout designs may be in one or more layers of a sample.

A layout design may be stored in a layout file for a wafer design. The layout file can be in a Graphic Database System (GDS) format, Graphic Database System II (GDS II) format, an Open Artwork System Interchange Standard (OASIS) format, a Caltech Intermediate Format (CIF), etc. The wafer design may include patterns or structures for inclusion on the wafer. The patterns or structures can be mask patterns used to transfer features from the photolithography masks or reticles to a wafer. In some embodiments, a layout in GDS or OASIS format, among others, may comprise feature information stored in a binary file format representing planar geometric shapes, text, and other information related to the wafer design. In some embodiments, a layout design may correspond to a field of view (FOV) of inspection system 610 (e.g., a FOV of inspection system 610 may include one or more layout structures of a layout design). In some embodiments, a layout design may be selected based on inspected samples (e.g., based on layouts that have been identified on a sample). Layout component 620 may transmit data including the selected one or more layout designs to conductive path component 630.

Conductive path component 630 may include a processor 632 and a storage 634. Conductive path component 630 may also include a communication interface 636 to receive data from layout component 620 and to send data to simulation component 640. Processor 632 may be configured to receive one or more selected layout designs from layout component 620. Processor 632 may be configured to define one or more conductive paths in the selected one or more layout designs. For example, some parts of a sample may be conductive while some other parts of a sample may be insulating. The one or more conductive paths in a sample may be used to generate an expected voltage contrast image of a sample.

For example, a sample with two layers connected by one or more vias and perfect overlay may have a perfect conductive path between the two layers. A sample with two layers connected by one or more vias and an overlay defect may not have a perfect conductive path between the two layers. An expected voltage contrast image of the sample with a perfect conductive path may be different from an expected voltage contrast image of the sample with an overlay defect. Therefore, processor 632 may define the conductive paths in a sample (e.g., a conductive path in a layer, one or more conductive paths in a plurality of layers, a conductive path in a plurality of layers, a layer with a plurality of conductive paths, etc.) based on the selected one or more layout designs. That is, voltage contrast images may be generated to have different voltage contrast patterns (e.g., pattern sets of voltage contrast image 500a of Fig. 5A, voltage contrast pattern 510b of Fig. 5B) depending on the layout designs used in a sample. Conductive path component 630 may transmit data including the defined one or more conductive paths and the selected one or more layout designs to simulation component 640.

Simulation component 640 may include a processor 642 and a storage 644. Simulation component 640 may also include a communication interface 646 to receive data from conductive path component 630 and to send data to classification component 650. Processor 642 may be configured to receive one or more defined conductive paths and one or more layout designs from conductive path component 630. Processor 642 may be configured to perform one or more perturbation simulations using one or more layout designs and one or more defined conductive paths. For example, perturbation simulations of a sample may be used to build different sensitivities in relationships between root causes of defects and voltage contrast patterns in voltage contrast images.

For example, perturbation simulations may simulate experiments of sample patterning where errors may be induced in the sample (e.g., placement errors, critical dimension errors, overlay errors, size errors, etc.). In some embodiments, the errors may be within a layer or between different layers of a sample. For example, overlay errors may be simulated by simulating layout designs in different layers of a sample, where the layout designs may be displaced from each other in a top view of the sample. In some embodiments, the simulations may include groups of layout designs on a sample. In some embodiments, processor 642 may simulate different patterning steps or materials used in sample processing.

In some embodiments, a layout file of a layout design (e.g., in GDS format) may be used to simulate overlay or critical dimension differences (e.g., defects) for one or more layers in a sample so that system 600 may identify specific layers containing defects and identify the root cause of the defects during inspection of the sample.

In some embodiments, processor 642 may generate one or more voltage contrast images based on the one or more perturbation simulations, where each voltage contrast image may have a voltage contrast pattern (e.g., pattern sets of voltage contrast image 500a of Fig. 5A, voltage contrast pattern 510b of Fig. 5B). Processor 642 may advantageously simulate experiments to save resources (e.g., time, cost, etc.) by avoiding actual experimentation on samples.

Simulation component 640 may transmit data including the perturbation simulations and the generated voltage contrast images to classification component 650.

Classification component 650 may include a processor 652 and a storage 654. Classification component 650 may also include a communication interface 656 to receive data from simulation component 640. Processor 652 may be configured to receive perturbation simulations and one or more generated voltage contrast images from simulation component 640. Processor 652 may be configured to construct a classifier by comparing the one or more voltage contrast images generated by processor 642 and determining one or more relationships (e.g., correlations) between one or more perturbation simulations and one or more voltage contrast patterns. For example, based on one or more perturbation simulations, processor 652 may derive relationships between different failure mechanisms associated with layout designs of a sample (e.g., layout designs with different root causes of failure or defect, layout designs that are known to result in failures or defects, etc.) and an expected (e.g., observed or corresponding) voltage contrast pattern of a voltage contrast image.

In some embodiments, processor 652 may construct a classifier by building a look-up table, using machine learning (e.g., a classifier algorithm), etc.

Classification component 650 may transmit data including the classifier to inspection system 610.

Inspection system 610 may use a classifier constructed by classification component 650 during inspection of one or more samples. For example, inspection system 610 may generate one or more voltage contrast images of a sample during inspection, where the voltage contrast images include one or more voltage contrast patterns. Inspection system 610 may use the classifier to identify (e.g., recognize) a voltage contrast pattern and determine one or more failure mechanisms (e.g., root causes of any failures or defects) of the sample. Inspection system 610 may advantageously classify failures or defects (e.g., placement errors, critical dimension errors, overlay errors, size errors, etc.) during inspection automatically using the classifier. In some embodiments, inspection system 610 may use the classifier to advantageously identify specific layers in which one or more defects exist during inspection based on the generated voltage contrast pattern.

For example, inspection system 610 may generate a voltage contrast image of a sample including a voltage contrast pattern. The voltage contrast pattern (e.g., pattern sets of voltage contrast image 500a of Fig. 5A) may include defects (e.g., feature 534a of Fig. 5A, feature 544a of Fig. 5A) related to use of a SADP process (e.g., a defect in a pattern set 540a of two features of Fig. 5A) or a SAQP process (e.g., a defect in a pattern set 530a of four features of Fig. 5A). Inspection system 610 may use the classifier to recognize the voltage contrast pattern and determine that the root cause of the defect (e.g., failure mechanism) in the sample is pitch walking from SADP or SAQP of the sample.

In some embodiments, inspection system 610 may generate a voltage contrast image of a sample including a voltage contrast pattern. The voltage contrast pattern (e.g., voltage contrast pattern 510b of Fig. 5B) may include a checkerboard pattern of features (e.g., features 520B of Fig. 5B that alternate in grey scale levels). Inspection system 610 may use the classifier to recognize the voltage contrast pattern and determine that the root cause of the defect (e.g., failure mechanism) in the sample is an overlay defect between layers of the sample.

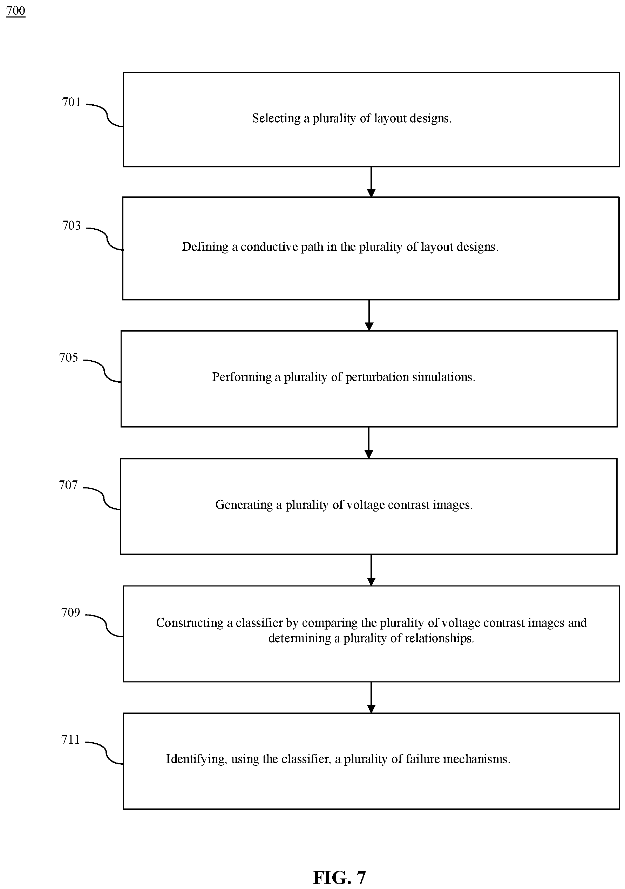

Reference is now made to Fig. 7, a flowchart illustrating an exemplary process 700 of classifying and identifying failure mechanisms associated with a sample, consistent with embodiments of the present disclosure. The steps of process 700 can be performed by a system (e.g., system 600 of Fig. 6) executing on or otherwise using the features of a computing device, e.g., controller 109 of Fig. 1 for purposes of illustration. It is appreciated that the illustrated method 700 can be altered to modify the order of steps and to include additional steps.

At step 701, the system (e.g., using processor 622 of Fig. 6) may select one or more layout designs, such as resist layout designs to be used for development (e.g., lithography) of a sample or final layer layout designs. In some embodiments, layout designs may reflect an internal design of a sample. A layout design may include one or more layout structures (e.g., layout of features) that may be developed on the sample. In some embodiments, one or more layout designs may be in one or more layers of a sample.

A layout design may be stored in a layout file for a wafer design. The layout file can be in a Graphic Database System (GDS) format, Graphic Database System II (GDS II) format, an Open Artwork System Interchange Standard (OASIS) format, a Caltech Intermediate Format (CIF), etc. The wafer design may include patterns or structures for inclusion on the wafer. The patterns or structures can be mask patterns used to transfer features from the photolithography masks or reticles to a wafer. In some embodiments, a layout in GDS or OASIS format, among others, may comprise feature information stored in a binary file format representing planar geometric shapes, text, and other information related to the wafer design. In some embodiments, a layout design may correspond to a field of view (FOV) of the system (e.g., inspection system 610 of Fig. 6).

At step 703, the system (processor 632 of Fig. 6) may define one or more conductive paths in the selected one or more layout designs. For example, some parts of a sample may be conductive while some other parts of a sample may be insulating. The one or more conductive paths in a sample may be used to generate an expected voltage contrast image of a sample. For example, a sample with two layers connected by one or more vias and perfect overlay may have a perfect conductive path between the two layers. A sample with two layers connected by one or more vias and an overlay defect may not have a perfect conductive path between the two layers. An expected voltage contrast image of the sample with a perfect conductive path may be different from an expected voltage contrast image of the sample with an overlay defect. Therefore, the system needs to define the conductive paths in a sample (e.g., a conductive path in a layer, one or more conductive paths in a plurality of layers, a conductive path in a plurality of layers, a layer with a plurality of conductive paths, etc.) based on the selected one or more layout designs.

At step 705, the system (e.g., processor 642 of Fig. 6) may perform one or more perturbation simulations using one or more pattern designs and one or more defined conductive paths. For example, perturbation simulations of a sample may be used to build different sensitivities in relationships between root causes of defects and voltage contrast patterns in voltage contrast images.

For example, perturbation simulations may simulate experiments of sample patterning where errors may be induced in the sample (e.g., placement errors, critical dimension errors, overlay errors, size errors, etc.). In some embodiments, the errors may be within a layer or between different layers of a sample. For example, overlay errors may be simulated by simulating layout designs in different layers of a sample, where the layout designs may be displaced from each other in a top view of the sample. In some embodiments, the simulations may include groups of layout designs on a sample. In some embodiments, the system may simulate different patterning steps or materials used in sample processing.

In some embodiments, a layout file of a layout design (e.g., in GDS format) may be used to simulate overlay or critical dimension differences (e.g., defects) for one or more layers in a sample so that the system may identify specific layers containing defects and identify the root cause of the defects during inspection of the sample.

At step 707, the system (e.g., processor 642 of Fig. 6) may generate one or more voltage contrast images based on the one or more perturbation simulations, where each voltage contrast image may have a voltage contrast pattern (e.g., pattern sets of voltage contrast image 500a of Fig. 5A, voltage contrast pattern 510b of Fig. 5B). For example, voltage contrast images may be generated to have different voltage contrast patterns (e.g., pattern sets of voltage contrast image 500a of Fig. 5A, voltage contrast pattern 510b of Fig. 5B) depending on the layout designs in a sample used in the perturbation simulations. The system may advantageously simulate experiments to save resources (e.g., time, cost, etc.) by avoiding actual experimentation on samples.

At step 709, the system (e.g., processor 652 of Fig. 6) can construct a classifier by comparing the generated voltage contrast images and determining one or more relationships (e.g., correlations) between one or more perturbation simulations and one or more voltage contrast patterns. For example, based on one or more perturbation simulations, the system may derive relationships between different failure mechanisms associated with layout designs of a sample (e.g., layout designs with different root causes of failure or defect, layout designs that are known to result in failures or defects, etc.) and an expected (e.g., observed or corresponding) voltage contrast pattern of a voltage contrast image.

In some embodiments, the system may construct a classifier by building a look-up table, using machine learning (e.g., a classifier algorithm), etc.

At step 711, the system (e.g., inspection system 610) may use the classifier during inspection to identify a plurality of failure mechanisms associated with one or more samples. For example, the system may generate one or more voltage contrast images of a sample during inspection, where the voltage contrast images include one or more voltage contrast patterns. The system may use the classifier to identify (e.g., recognize) a voltage contrast pattern and determine one or more failure mechanisms (e.g., root causes of any failures or defects) of the sample. The system may advantageously classify failures or defects (e.g., placement errors, critical dimension errors, overlay errors, size errors, etc.) during inspection automatically using the classifier. In some embodiments, the system may use the classifier to advantageously identify specific layers in which one or more defects exist during inspection based on the generated voltage contrast pattern.

For example, the system may generate a voltage contrast image of a sample including a voltage contrast pattern. The voltage contrast pattern (e.g., pattern sets of voltage contrast image 500a of Fig. 5A) may include defects (e.g., feature 534a of Fig. 5A, feature 544a of Fig. 5A) related to use of a SADP process (e.g., a defect in a pattern set 540a of two features of Fig. 5A) or a SAQP process (e.g., a defect in a pattern set 530a of four features of Fig. 5A). The system may use the classifier to recognize the voltage contrast pattern and determine that the root cause of the defect (e.g., failure mechanism) in the sample is pitch walking from SADP or SAQP of the sample.

In some embodiments, the system may generate a voltage contrast image of a sample including a voltage contrast pattern. The voltage contrast pattern (e.g., voltage contrast pattern 510b of Fig. 5B) may include a checkerboard pattern of features (e.g., features 520B of Fig. 5B that alternate in grey scale levels). The system may use the classifier to recognize the voltage contrast pattern and determine that the root cause of the defect (e.g., failure mechanism) in the sample is an overlay defect between layers of the sample.

A non-transitory computer readable medium may be provided that stores instructions for a processor of a controller (e.g., controller 109 of Fig. 1) for controlling the electron beam tool, consistent with embodiments in the present disclosure. Common forms of non-transitory media include, for example, a floppy disk, a flexible disk, hard disk, solid state drive, magnetic tape, or any other magnetic data storage medium, a Compact Disc Read Only Memory (CD-ROM), any other optical data storage medium, any physical medium with patterns of holes, a Random Access Memory (RAM), a Programmable Read Only Memory (PROM), and Erasable Programmable Read Only Memory (EPROM), a FLASH-EPROM or any other flash memory, Non-Volatile Random Access Memory (NVRAM), a cache, a register, any other memory chip or cartridge, and networked versions of the same.

The embodiments may further be described using the following clauses:
1. A method for identifying a failure mechanism, the method comprising:
   analyzing a first plurality of voltage contrast images of a sample to identify a plurality of defects; and
   analyzing a pattern of a subset of the plurality of defects to determine a failure mechanism for the subset of the plurality of defects.
2. The method of clause 1, further comprising analyzing a correlation between the pattern of the subset of the plurality of defects and a plurality of layout designs associated with the sample to facilitate determination of the failure mechanism.
3. The method of any one of clauses 1-2, further comprising analyzing the pattern of the subset of the plurality of defects to determine a classification for the subset of the defects.
4. The method of clause 3, wherein determining the failure mechanism and determining the classification further comprises using a classifier, wherein the classifier is constructed by:
   generating a second plurality of voltage contrast images based on a plurality of perturbation simulations, wherein the second plurality of voltage contrast images comprise a plurality of voltage contrast patterns; and
   comparing the second plurality of voltage contrast images and determining a plurality of correlations between the plurality of perturbation simulations and the second plurality of voltage contrast patterns.
5. The method of clause 4, further comprising performing the plurality of perturbation simulations by:
   selecting a plurality of layout designs, wherein the plurality of layout designs comprise a plurality of features of a sample; and
   defining a conductive path in the plurality of layout designs.
6. The method of clause 5, wherein the plurality of layout designs are within a plurality of layers in a sample.
7. The method of any one of clauses 5-6, wherein the conductive path comprises a plurality of conductive paths.
8. The method of any one of clauses 5-7, wherein each layout design of the plurality of layout designs comprises a defined conductive path.
9. The method of any one of clauses 5-7, wherein a subset of the plurality of layout designs comprises a defined conductive path.
10. The method of clause 9, wherein the subset of the plurality of layout designs comprises a plurality of layers in a sample.
11. The method of any one of clauses 4-10, wherein generating a second plurality of voltage contrast images based on a plurality of perturbation simulations comprises inducing an error in a sample.
12. The method of clause 11, wherein the error comprises any one of a placement error, a critical dimension error, an overlay error, or a size error.
13. The method of any one of clauses 11-12, wherein the error is within a layer of a sample.
14. The method of clause 13, wherein the layer is a plurality of layers.
15. The method of any one of clauses 4-14, wherein the plurality of perturbation simulations comprises a plurality of simulated patterning steps during processing of a sample.
16. The method of any one of clauses 4-15, wherein the plurality of perturbation simulations comprises a plurality of materials used during processing of a sample.
17. The method of any one of clauses 4-16, wherein each voltage contrast pattern of the second plurality of voltage contrast patterns comprises a layout of features on a sample.
18. The method of any one of clauses 4-17, wherein the plurality of failure mechanisms comprises a plurality of root causes of a defect in a sample.
19. The method of clause 18, wherein the defect is within a layer of the sample.
20. The method of clause 19, wherein the layer is a plurality of layers.
21. The method of any one of clauses 1-20, wherein the pattern of the subset of the plurality of defects of the first plurality of voltage contrast images comprises a repeating pattern of features.
22. The method of clause 21, wherein the failure mechanism for the subset of the plurality of defects comprises pitch walking due to any one of self-aligned double patterning or self-aligned quadruple patterning of a sample.
23. The method of any one of clauses 1-20, wherein the pattern of the subset of the plurality of defects of the first plurality of voltage contrast images comprises a checkerboard of features.
24. The method of clause 23, wherein the failure mechanism for the subset of the plurality of defects comprises an overlay defect between a plurality of layers of a sample.
25. A system for identifying a failure mechanism, the system comprising:
   a controller including circuitry configured to cause the system to perform:
   analyzing a first plurality of voltage contrast images of a sample to identify a plurality of defects; and
   analyzing a pattern of a subset of the plurality of defects to determine a failure mechanism for the subset of the plurality of defects.
26. The system of clause 25, wherein the controller includes circuitry configured to cause the system to further perform:
   analyzing a correlation between the pattern of the subset of the plurality of defects and a plurality of layout designs associated with the sample to facilitate determination of the failure mechanism.
27. The system of any one of clauses 25-26, wherein the controller includes circuitry configured to cause the system to further perform analyzing the pattern of the subset of the plurality of defects to determine a classification for the subset of the defects.
28. The system of clause 27, wherein determining the failure mechanism and determining the classification further comprises using a classifier, wherein the classifier is constructed by:
   generating a second plurality of voltage contrast images based on a plurality of perturbation simulations, wherein the second plurality of voltage contrast images comprise a plurality of voltage contrast patterns; and
   comparing the second plurality of voltage contrast images and determining a plurality of correlations between the plurality of perturbation simulations and the second plurality of voltage contrast patterns.
29. The system of clause 28, wherein the controller includes circuitry configured to cause the system to further perform the plurality of perturbation simulations by:
   selecting a plurality of layout designs, wherein the plurality of layout designs comprise a plurality of features of a sample; and
   defining a conductive path in the plurality of layout designs.
30. The system of clause 29, wherein the plurality of layout designs are within a plurality of layers in a sample.
31. The system of any one of clauses 29-30, wherein the conductive path comprises a plurality of conductive paths.
32. The system of any one of clauses 29-31, wherein each layout design of the plurality of layout designs comprises a defined conductive path.
33. The system of any one of clauses 29-31, wherein a subset of the plurality of layout designs comprises a defined conductive path.
34. The system of clause 33, wherein the subset of the plurality of layout designs comprises a plurality of layers in a sample.
35. The system of any one of clauses 28-34, wherein generating a second plurality of voltage contrast images based on a plurality of perturbation simulations comprises inducing an error in a sample.
36. The system of clause 35, wherein the error comprises any one of a placement error, a critical dimension error, an overlay error, or a size error.
37. The system of any one of clauses 35-36, wherein the error is within a layer of a sample.
38. The system of clause 37, wherein the layer is a plurality of layers.
39. The system of any one of clauses 28-38, wherein the plurality of perturbation simulations comprises a plurality of simulated patterning steps during processing of a sample.
40. The system of any one of clauses 28-39, wherein the plurality of perturbation simulations comprises a plurality of materials used during processing of a sample.
41. The system of any one of clauses 28-40, wherein each voltage contrast pattern of the second plurality of voltage contrast patterns comprises a layout of features on a sample.
42. The system of any one of clauses 28-41, wherein the plurality of failure mechanisms comprise a plurality of root causes of a defect in a sample.
43. The system of clause 42, wherein the defect is within a layer of the sample.
44. The system of clause 43, wherein the layer is a plurality of layers.
45. The system of any one of clauses 25-44, wherein the pattern of the subset of the plurality of defects of the first plurality of voltage contrast images comprises a repeating pattern of features.
46. The system of clause 45, wherein the failure mechanism for the subset of the plurality of defects comprises pitch walking due to any one of self-aligned double patterning or self-aligned quadruple patterning of a sample.
47. The system of any one of clauses 25-44, wherein the pattern of the subset of the plurality of defects of the first plurality of voltage contrast images comprises a checkerboard of features.
48. The system of clause 47, wherein the failure mechanism for the subset of the plurality of defects comprises an overlay defect between a plurality of layers of a sample.
49. A non-transitory computer readable medium that stores a set of instructions that is executable by at least one processor of a computing device to cause the computing device to perform a method for classifying and identifying failure mechanisms, the method comprising:
   analyzing a first plurality of voltage contrast images of a sample to identify a plurality of defects; and
   analyzing a pattern of a subset of the plurality of defects to determine a failure mechanism for the subset of the plurality of defects.
50. The non-transitory computer readable medium of clause 49, wherein the set of instructions that is executable by at least one processor of a computing device to cause the computing device to further perform:
   analyzing a correlation between the pattern of the subset of the plurality of defects and a plurality of layout designs associated with the sample to facilitate determination of the failure mechanism.
51. The non-transitory computer readable medium of any one of clauses 49-50, wherein the set of instructions that is executable by at least one processor of a computing device to cause the computing device to further perform analyzing the pattern of the subset of the plurality of defects to determine a classification for the subset of the defects.
52. The non-transitory computer readable medium of clause 51, wherein determining the failure mechanism and determining the classification further comprises using a classifier, wherein the classifier is constructed by:
   generating a second plurality of voltage contrast images based on a plurality of perturbation simulations, wherein the second plurality of voltage contrast images comprise a plurality of voltage contrast patterns; and
   comparing the second plurality of voltage contrast images and determining a plurality of correlations between the plurality of perturbation simulations and the second plurality of voltage contrast patterns.
53. The non-transitory computer readable medium of clause 52, wherein the set of instructions that is executable by at least one processor of a computing device to cause the computing device to further perform the plurality of perturbation simulations by:
   selecting a plurality of layout designs, wherein the plurality of layout designs comprise a plurality of features of a sample; and
   defining a conductive path in the plurality of layout designs.
54. The non-transitory computer readable medium of clause 53, wherein the plurality of layout designs are within a plurality of layers in a sample.
55. The non-transitory computer readable medium of any one of clauses 53-54, wherein the conductive path comprises a plurality of conductive paths.
56. The non-transitory computer readable medium of any one of clauses 53-55, wherein each layout design of the plurality of layout designs comprises a defined conductive path.
57. The non-transitory computer readable medium of any one of clauses 53-55, wherein a subset of the plurality of layout designs comprises a defined conductive path.
58. The non-transitory computer readable medium of clause 57, wherein the subset of the plurality of layout designs comprises a plurality of layers in a sample.
59. The non-transitory computer readable medium of any one of clauses 52-58, wherein generating a second plurality of voltage contrast images based on a plurality of perturbation simulations comprises inducing an error in a sample.
60. The non-transitory computer readable medium of clause 59, wherein the error comprises any one of a placement error, a critical dimension error, an overlay error, or a size error.
61. The non-transitory computer readable medium of any one of clauses 59-60, wherein the error is within a layer of a sample.
62. The non-transitory computer readable medium of clause 61, wherein the layer is a plurality of layers.
63. The non-transitory computer readable medium of any one of clauses 52-62, wherein the plurality of perturbation simulations comprises a plurality of simulated patterning steps during processing of a sample.
64. The non-transitory computer readable medium of any one of clauses 52-63, wherein the plurality of perturbation simulations comprises a plurality of materials used during processing of a sample.
65. The non-transitory computer readable medium of any one of clauses 52-64, wherein each voltage contrast pattern of the second plurality of voltage contrast patterns comprises a layout of features on a sample.
66. The non-transitory computer readable medium of any one of clauses 52-65, wherein the plurality of failure mechanisms comprise a plurality of root causes of a defect in a sample.
67. The non-transitory computer readable medium of clause 66, wherein the defect is within a layer of the sample.
68. The non-transitory computer readable medium of clause 67, wherein the layer is a plurality of layers.
69. The non-transitory computer readable medium of any one of clauses 49-68, wherein the pattern of the subset of the plurality of defects of the first plurality of voltage contrast images comprises a repeating pattern of features.
70. The non-transitory computer readable medium of clause 69, wherein the failure mechanism for the subset of the plurality of defects comprises pitch walking due to any one of self-aligned double patterning or self-aligned quadruple patterning of a sample.
71. The non-transitory computer readable medium of any one of clauses 49-68, wherein the pattern of the subset of the plurality of defects of the first plurality of voltage contrast images comprises a checkerboard of features.
72. The non-transitory computer readable medium of clause 71, wherein the failure mechanism for the subset of the plurality of defects comprises an overlay defect between a plurality of layers of a sample.
73. A system for classifying and identifying failure mechanisms, the system comprising:
   a controller including circuitry configured to cause the system to perform:
   generating a first plurality of voltage contrast patterns based on a plurality of perturbation simulations;
   determining a relationship between the plurality of perturbation simulations and the first plurality of voltage contrast patterns;
   generating a second plurality of voltage contrast patterns; and
   identifying a failure mechanism based on the second plurality of voltage contrast patterns and the plurality of relationships.
74. The system of clause 73, wherein the controller includes circuitry configured to cause the system to further perform the plurality of perturbation simulations by:
   selecting a plurality of layout designs, wherein the plurality of layout designs comprise a plurality of features of a sample; and
   defining a conductive path in the plurality of layout designs.
75. The system of clause 74, wherein the plurality of layout designs are within a plurality of layers in a sample.
76. The system of any one of clauses 74-75, wherein the conductive path comprises a plurality of conductive paths.
77. The system of any one of clauses 74-76, wherein each layout design of the plurality of layout designs comprises a defined conductive path.
78. The system of any one of clauses 74-76, wherein a subset of the plurality of layout designs comprises a defined conductive path.
79. The system of clause 78, wherein the subset of the plurality of layout designs comprises a plurality of layers in a sample.
80. The system of any one of clauses 73-79, wherein generating the first plurality of voltage contrast patterns based on the plurality of perturbation simulations comprises inducing an error in a sample.
81. The system of clause 80, wherein the error comprises any one of a placement error, a critical dimension error, an overlay error, or a size error.
82. The system of any one of clauses 80-81, wherein the error is within a layer of a sample.
83. The system of clause 82, wherein the layer is a plurality of layers.
84. The system of any one of clauses 73-83, wherein the plurality of perturbation simulations comprises a plurality of simulated patterning steps during processing of a sample.
85. The system of any one of clauses 73-84, wherein the plurality of perturbation simulations comprises a plurality of materials used during processing of a sample.
86. The system of any one of clauses 73-85, wherein each voltage contrast pattern of the first plurality of voltage contrast patterns comprises a layout of features on a sample.
87. The system of any one of clauses 73-86, wherein the failure mechanism comprises a root cause of a defect in a sample.
88. The system of clause 87, wherein the defect is within a layer of the sample.
89. The system of clause 88, wherein the layer is a plurality of layers.
90. The system of any one of clauses 73-89, wherein a voltage contrast pattern of the second plurality of voltage contrast patterns comprises a repeating pattern of features.
91. The system of clause 90, wherein a failure mechanism of the voltage contrast pattern comprises pitch walking due to any one of self-aligned double patterning or self-aligned quadruple patterning of a sample.
92. The system of any one of clauses 73-89, wherein a voltage contrast pattern of the second plurality of voltage contrast patterns comprises a checkerboard of features.
93. The system of clause 92, wherein a failure mechanism of the voltage contrast pattern comprises an overlay defect between a plurality of layers of a sample.
94. A method for classifying and identifying failure mechanisms, the method comprising:
   generating a first plurality of voltage contrast patterns based on a plurality of perturbation simulations;
   determining a relationship between the plurality of perturbation simulations and the first plurality of voltage contrast patterns;
   generating a second plurality of voltage contrast patterns; and
   identifying a failure mechanism based on the second plurality of voltage contrast patterns and the plurality of relationships.
95. The method of clause 94, further comprising performing the plurality of perturbation simulations by:
   selecting a plurality of layout designs, wherein the plurality of layout designs comprise a plurality of features of a sample; and
   defining a conductive path in the plurality of layout designs.
96. The method of clause 95, wherein the plurality of layout designs are within a plurality of layers in a sample.
97. The method of any one of clauses 95-96, wherein the conductive path comprises a plurality of conductive paths.
98. The method of any one of clauses 95-97, wherein each layout design of the plurality of layout designs comprises a defined conductive path.
99. The method of any one of clauses 95-97, wherein a subset of the plurality of layout designs comprises a defined conductive path.
100. The method of clause 99, wherein the subset of the plurality of layout designs comprises a plurality of layers in a sample.
101. The method of any one of clauses 94-100, wherein generating the first plurality of voltage contrast patterns based on the plurality of perturbation simulations comprises inducing an error in a sample.
102. The method of clause 101, wherein the error comprises any one of a placement error, a critical dimension error, an overlay error, or a size error.
103. The method of any one of clauses 101-102, wherein the error is within a layer of a sample.
104. The method of clause 103, wherein the layer is a plurality of layers.
105. The method of any one of clauses 94-104, wherein the plurality of perturbation simulations comprises a plurality of simulated patterning steps during processing of a sample.
106. The method of any one of clauses 94-105, wherein the plurality of perturbation simulations comprises a plurality of materials used during processing of a sample.
107. The method of any one of clauses 94-106, wherein each voltage contrast pattern of the first plurality of voltage contrast patterns comprises a layout of features on a sample.
108. The method of any one of clauses 94-107, wherein the failure mechanism comprises a root cause of a defect in a sample.
109. The method of clause 108, wherein the defect is within a layer of the sample.
110. The method of clause 109, wherein the layer is a plurality of layers.
111. The method of any one of clauses 94-110, wherein a voltage contrast pattern of the second plurality of voltage contrast patterns comprises a repeating pattern of features.
112. The method of clause 111, wherein a failure mechanism of the voltage contrast pattern comprises pitch walking due to any one of self-aligned double patterning or self-aligned quadruple patterning of a sample.
113. The method of any one of clauses 94-110, wherein a voltage contrast pattern of the second plurality of voltage contrast patterns comprises a checkerboard of features.
114. The method of clause 113, wherein a failure mechanism of the voltage contrast pattern comprises an overlay defect between a plurality of layers of a sample.
115. A non-transitory computer readable medium that stores a set of instructions that is executable by at least one processor of a computing device to cause the computing device to perform a method for classifying and identifying failure mechanisms, the method comprising:
   generating a first plurality of voltage contrast patterns based on a plurality of perturbation simulations;
   determining a relationship between the plurality of perturbation simulations and the first plurality of voltage contrast patterns;
   generating a second plurality of voltage contrast patterns; and
   identifying a failure mechanism based on the second plurality of voltage contrast patterns and the plurality of relationships.
116. The non-transitory computer readable medium of clause 115, wherein the set of instructions that is executable by at least one processor of a computing device to cause the computing device to further perform the plurality of perturbation simulations by:
   selecting a plurality of layout designs, wherein the plurality of layout designs comprise a plurality of features of a sample; and
   defining a conductive path in the plurality of layout designs.
117. The non-transitory computer readable medium of clause 116, wherein the plurality of layout designs are within a plurality of layers in a sample.
118. The non-transitory computer readable medium of any one of clauses 116-117, wherein the conductive path comprises a plurality of conductive paths.
119. The non-transitory computer readable medium of any one of clauses 116-118, wherein each layout design of the plurality of layout designs comprises a defined conductive path.
120. The non-transitory computer readable medium of any one of clauses 116-118, wherein a subset of the plurality of layout designs comprises a defined conductive path.
121. The non-transitory computer readable medium of clause 120, wherein the subset of the plurality of layout designs comprises a plurality of layers in a sample.
122. The non-transitory computer readable medium of any one of clauses 115-121, wherein generating the first plurality of voltage contrast patterns based on the plurality of perturbation simulations comprises inducing an error in a sample.
123. The non-transitory computer readable medium of clause 122, wherein the error comprises any one of a placement error, a critical dimension error, an overlay error, or a size error.
124. The non-transitory computer readable medium of any one of clauses 122-123, wherein the error is within a layer of a sample.
125. The non-transitory computer readable medium of clause 124, wherein the layer is a plurality of layers.
126. The non-transitory computer readable medium of any one of clauses 115-125, wherein the plurality of perturbation simulations comprises a plurality of simulated patterning steps during processing of a sample.
127. The non-transitory computer readable medium of any one of clauses 115-126, wherein the plurality of perturbation simulations comprises a plurality of materials used during processing of a sample.
128. The non-transitory computer readable medium of any one of clauses 115-127, wherein each voltage contrast pattern of the first plurality of voltage contrast patterns comprises a layout of features on a sample.
129. The non-transitory computer readable medium of any one of clauses 115-128, wherein the failure mechanism comprise a root cause of a defect in a sample.
130. The non-transitory computer readable medium of clause 129, wherein the defect is within a layer of the sample.
131. The non-transitory computer readable medium of clause 130, wherein the layer is a plurality of layers.
132. The non-transitory computer readable medium of any one of clauses 115-131, wherein a voltage contrast pattern of the second plurality of voltage contrast patterns comprises a repeating pattern of features.
133. The non-transitory computer readable medium of clause 132, wherein a failure mechanism of the voltage contrast pattern comprises pitch walking due to any one of self-aligned double patterning or self-aligned quadruple patterning of a sample.
134. The non-transitory computer readable medium of any one of clauses 115-131, wherein a voltage contrast pattern of the second plurality of voltage contrast patterns comprises a checkerboard of features.
135. The non-transitory computer readable medium of clause 134, wherein a failure mechanism of the voltage contrast pattern comprises an overlay defect between a plurality of layers of a sample.
136. A system for classifying and identifying failure mechanisms, the system comprising:
   a controller including circuitry configured to cause the system to perform:
   generating a first plurality of voltage contrast patterns based on a plurality of perturbation simulations;
   classifying a failure mechanism associated with the first plurality of voltage contrast based on a relationship between the plurality of perturbation simulations and the first plurality of voltage contrast patterns;
   generating a second plurality of voltage contrast patterns; and
   identifying, using the classified failure mechanism, a failure mechanism associated with the second plurality of voltage contrast patterns.
137. A system for classifying and identifying failure mechanisms, the system comprising:
   a controller including circuitry configured to cause the system to perform:
   generating a first plurality of voltage contrast images based on a plurality of perturbation simulations, wherein the first plurality of voltage contrast images comprise a first plurality of voltage contrast patterns;
   constructing a classifier by comparing the first plurality of voltage contrast images and determining a relationship between the plurality of perturbation simulations and the first plurality of voltage contrast patterns;
   generating a second plurality of voltage contrast images during inspection, wherein the second plurality of voltage contrast images comprise a second plurality of voltage contrast patterns;
   identifying, using the classifier, a failure mechanism based on the second plurality of voltage contrast patterns.
138. The method of clause 1, wherein the pattern comprises a plurality of pattern sets, each pattern set of the plurality of pattern sets comprising two features and a defect associated with the two features.
139. The method of clause 138, wherein the two features of each pattern set indicates that the two features are manufactured by use of a self-aligned double patterning process and wherein the defect indicates a failure mechanism related to the use of the self-aligned double patterning process.
140. The method of clause 1, wherein the pattern comprises a plurality of pattern sets, each pattern set of the plurality of pattern sets comprising four features and a defect associated with the four features.
141. The method of clause 140, wherein the four features of each pattern set indicates that the four features are manufactured by use of a self-aligned quadruple patterning process and wherein the defect indicates a failure mechanism related to the use of the self-aligned quadruple patterning process.
142. The system of clause 25, wherein the pattern comprises a plurality of pattern sets, each pattern set of the plurality of pattern sets comprising two features and a defect associated with the two features.
143. The method of clause 142, wherein the two features of each pattern set indicates that the two features are manufactured by use of a self-aligned double patterning process and wherein the defect indicates a failure mechanism related to the use of the self-aligned double patterning process.
144. The system of clause 25, wherein the pattern comprises a plurality of pattern sets, each pattern set of the plurality of pattern sets comprising four features and a defect associated with the four features.
145. The method of clause 144, wherein the four features of each pattern set indicates that the four features are manufactured by use of a self-aligned quadruple patterning process and wherein the defect indicates a failure mechanism related to the use of the self-aligned quadruple patterning process.
146. The non-transitory computer readable medium of clause 49, wherein the pattern comprises a plurality of pattern sets, each pattern set of the plurality of pattern sets comprising two features and a defect associated with the two features.
147. The non-transitory computer readable medium of clause 146, wherein the two features of each pattern set indicates that the two features are manufactured by use of a self-aligned double patterning process and wherein the defect indicates a failure mechanism related to the use of the self-aligned double patterning process.
148. The non-transitory computer readable medium of clause 49, wherein the pattern comprises a plurality of pattern sets, each pattern set of the plurality of pattern sets comprising four features and a defect associated with the four features.
149. The non-transitory computer readable medium of clause 148, wherein the four features of each pattern set indicates that the four features are manufactured by use of a self-aligned quadruple patterning process and wherein the defect indicates a failure mechanism related to the use of the self-aligned quadruple patterning process.
150. The system of any one of clauses 73-93, wherein the relationship comprises a plurality of relationships.
151. The system of any one of clauses 73-93 or 150, wherein the failure mechanism comprises a plurality of failure mechanism.
152. The method of any one of clauses 94-114, wherein the relationship comprises a plurality of relationships.
153. The method of any one of clauses 94-114 or 152, wherein the failure mechanism comprises a plurality of failure mechanism.
154. The non-transitory computer readable medium of any one of clauses 115-135, wherein the relationship comprises a plurality of relationships.
155. The non-transitory computer readable medium of any one of clauses 115-135 or 154, wherein the failure mechanism comprises a plurality of failure mechanism.

It will be appreciated that the embodiments of the present disclosure are not limited to the exact construction that has been described above and illustrated in the accompanying drawings, and that various modifications and changes may be made without departing from the scope thereof.

## Claims

1. A system for identifying a failure mechanism, the system comprising:
a controller including circuitry configured to cause the system to perform:
analyzing a first plurality of voltage contrast images of a sample to identify a plurality of defects; and
analyzing a pattern of a subset of the plurality of defects to determine a failure mechanism for the subset of the plurality of defects.

2. The system of claim 1, wherein the controller includes circuitry configured to cause the system to further perform:
analyzing a correlation between the pattern of the subset of the plurality of defects and a plurality of layout designs associated with the sample to facilitate determination of the failure mechanism.

3. The system of claim 1, wherein the controller includes circuitry configured to cause the system to further perform analyzing the pattern of the subset of the plurality of defects to determine a classification for the subset of the defects.

4. The system of claim 3, wherein determining the failure mechanism and determining the classification further comprises using a classifier, wherein the classifier is constructed by:
generating a second plurality of voltage contrast images based on a plurality of perturbation simulations, wherein the second plurality of voltage contrast images comprise a plurality of voltage contrast patterns; and
comparing the second plurality of voltage contrast images and determining a plurality of correlations between the plurality of perturbation simulations and the second plurality of voltage contrast patterns.

5. The system of claim 4, wherein the controller includes circuitry configured to cause the system to further perform the plurality of perturbation simulations by:
selecting a plurality of layout designs, wherein the plurality of layout designs comprise a plurality of features of a sample; and
defining a conductive path in the plurality of layout designs.

6. The system of claim 4, wherein the plurality of perturbation simulations comprises a plurality of simulated patterning steps during processing of a sample.

7. The system of claim 4, wherein the plurality of perturbation simulations comprises a plurality of materials used during processing of a sample.

8. The system of claim 4, wherein each voltage contrast pattern of the second plurality of voltage contrast patterns comprises a layout of features on a sample.

9. The system of any one of claims 4, wherein the plurality of failure mechanisms comprise a plurality of root causes of a defect in a sample.

10. The system of claim 9, wherein the defect is within a layer of the sample.

11. The system of claim 1, wherein the pattern of the subset of the plurality of defects of the first plurality of voltage contrast images comprises a repeating pattern of features.

12. The system of claim 11, wherein the failure mechanism for the subset of the plurality of defects comprises pitch walking due to any one of self-aligned double patterning or self-aligned quadruple patterning of a sample.

13. The system of claim 1, wherein the pattern of the subset of the plurality of defects of the first plurality of voltage contrast images comprises a checkerboard of features.

14. The system of claim 13, wherein the failure mechanism for the subset of the plurality of defects comprises an overlay defect between a plurality of layers of a sample.

15. A non-transitory computer readable medium that stores a set of instructions that is executable by at least one processor of a computing device to cause the computing device to perform a method for classifying and identifying failure mechanisms, the method comprising:
analyzing a first plurality of voltage contrast images of a sample to identify a plurality of defects; and
analyzing a pattern of a subset of the plurality of defects to determine a failure mechanism for the subset of the plurality of defects.
